# EUROPEAN PATENT APPLICATION

(11) **EP 4 576 229 A1**
(43) Date of publication of application: **25.06.2025**
(21) Application number: 23899734.0
(22) Date of filing: 17.11.2023
(51) Int. Cl.: H01L 33/20, H01L 33/46, H01L 33/00

(54) **ULTRAVIOLET LIGHT-EMITTING DIODE AND MANUFACTURING METHOD THEREFOR**

(30) Priority: 09.12.2022 CN 202211587031
(71) Applicant: Suzhou Uvcantek Co., Ltd, Suzhou, Jiangsu 215000 (CN)
(72) Inventor: ZHANG, Shuang, Suzhou, Jiangsu 215200 (CN); YUE, Jinshun, Suzhou, Jiangsu 215200 (CN); CHEN, Jingwen, Suzhou, Jiangsu 215200 (CN); WANG, Yongzhong, Suzhou, Jiangsu 215200 (CN)
(74) Representative: Valet Patent Services Limited
(86) International application number: PCT/CN2023/132306
(87) International publication number: WO 2024/120154

(57) **Abstract**

An ultraviolet light-emitting diode and a method for manufacturing an ultraviolet light-emitting diode are provide according to embodiments of the invention. The ultraviolet LED (100) includes a first trench (a1) which is extended from a P-type layer (25) to an N-type layer (22), and a second trench (a2) which is extended from the N-type layer (22) that is a bottom of the first trench (a1) to a buffer layer (21) or a substrate (10). The N-type electrode (30) is disposed on the N-type layer (22) which is the bottom of the first trench (a1). The P-type electrode (40) is disposed on the P-type layer (25) which is outside the first trench (a1).

## Description

### CROSS-REFERENCE TO RELATED APPLICATIONS

This application claims a priority to a Chinese patent application No. 202211587031.2, filed on December 9, 2022, and entitled "Ultraviolet light-emitting diode and manufacturing method therefor", the entire content of which is incorporated herein by reference.

### TECHNICAL FIELD

The invention relates to a technical field of semiconductor technology, and in particular to an ultraviolet light-emitting diode and a method for manufacturing an ultraviolet light-emitting diode.

### BACKGROUND

An ultraviolet light-emitting diode (LED) based on (Al)GaN material is widely used in fields of air purification, sterilization and disinfection, ultraviolet light therapy, biochemical detection, confidential communication and the like, and is an important research topic in a field of nitride semiconductor research.

However, (Al)GaN-based Ultra Violet (UV) LED has unique optical polarization properties. First, as an Al component continually increase, a wavelength of light emitted by the UV LED becomes shorter, and a polarization state of light transforms from a transverse electric polarization mode (TE) to a transverse magnetic polarization mode (TM). In turn, since a refractive index of AlGaN is significantly different from that of air and a TM polarized light mainly propagates in a horizontal direction, an interface incident angle is large. An effect of total reflection occurring at an interface among different materials may result in a very low light extraction efficiency (LEE) of (Al)GaN-based UV LED, thereby seriously reducing a light output efficiency of the ultraviolet light-emitting diode.

### SUMMARY

In order to overcome the above-mentioned defects of the related art, an ultraviolet light-emitting diode and a method for manufacturing an ultraviolet light-emitting diode are provided according to embodiments of the invention. The problem of low light extraction efficiency of ultraviolet light-emitting diodes in related art can be solved by utilizing one or more embodiments of the invention.

In a first aspect of the embodiments of the invention, a UV light-emitting diode is provided, comprising a substrate, an epitaxial layer, an N-type electrode and a P-type electrode, wherein the epitaxial layer comprises a buffer layer, an N-type layer, a multi-quantum-wells layer and a P-type layer sequentially stacked on the substrate; the ultraviolet LED has a first trench and a second trench, the first trench being extended from the P-type layer to the N-type layer, a bottom of the first trench being the N-type layer, the N-type electrode being disposed on the N-type layer which is the bottom of the first trench, the P-type electrode being disposed on the P-type layer which is outside the first trench, wherein the second trench is extended from the N-type layer which is the bottom of the first trench to the buffer layer or the substrate, a bottom of the second trench being the buffer layer or the substrate.

In a second aspect of the embodiments of the invention, a method for manufacturing an ultraviolet light-emitting diode is provided, the method includes: growing an epitaxial layer on a substrate to obtain an epitaxial wafer, where the epitaxial layer includes a buffer layer, an N-type layer, a multi-quantum-wells layer and a P-type layer grown in sequence on the substrate; performing an etchings on the epitaxial layer a plurality of times to form a first trench and a second trench on the epitaxial layer, the first trench being extended from the P-type layer to the N-type layer, a bottom of the first trench being the N-type layer, the second trench being extended from the N-type layer which is a bottom of the first trench to the buffer layer or the substrate, a bottom of the second trench being the buffer layer or the substrate; forming an N-type electrode on the N-type layer which is the bottom of the first trench; forming a P-type electrode on the P-type layer which is outside the first trench.

### BRIEF DESCRIPTION OF DRAWINGS

FIG. 1 shows a cross-sectional schematic diagram of an ultraviolet light-emitting diode according to some embodiments of the invention;
FIG. 2 shows a flow chart of a method for manufacturing an ultraviolet light-emitting diode according to some embodiments of the invention; and
FIG. 3 shows a cross-sectional schematic diagram of an epitaxial wafer which is etched according to some embodiments of the invention.

### DESCRIPTION OF EMBODIMENTS

In order to make the objectives, technical solutions and advantages of the invention more clear, the embodiments of the invention will be further described in detail below with reference to the accompanying drawings.

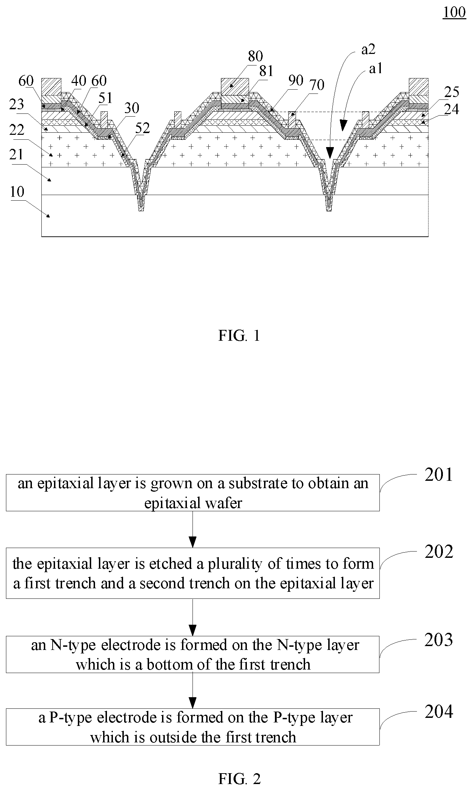

As shown in FIG. 1, the ultraviolet light-emitting diode (LED) 100 includes a substrate 10, an epitaxial layer, an N-type electrode 30 and a P-type electrode 40. The epitaxial layer includes a buffer layer 21, an N-type layer 22, a multi-quantum-well layer 23 and a P-type layer 25 which are sequentially stacked on the substrate 10.

The ultraviolet LED 100 has a first trench a1 and a second trench a2. The first trench a1 is extended from the P-type layer 25 to the N-type layer 22, and thus a bottom of the first trench a1 is the N-type layer 22. The N-type electrode 30 is disposed on the N-type layer 22 which is the bottom of the first trench a1. The P-type electrode 40 is disposed on the P-type layer 25 which is outside the first trench a1. The second trench a2 is extended from the N-type layer 22 which is the bottom of the first trench a1 to the buffer layer 21 or the substrate 10. When the second trench a2 is extended from the N-type layer 22 which is the bottom of the first trench a1 to the buffer layer 21, a bottom of the second trench a2 is the buffer layer 21. When the second trench a2 is extended from the N-type layer 22 which is the bottom of the first trench a1 to the substrate 10, a bottom of the second trench a2 is the substrate 10.

An internal structure of the ultraviolet LED is changed by forming the first trench and the second trench in the LED. The first trench is extended from the P-type layer to the N-type layer, and the second trench is extended from the N-type layer which is the bottom of the first trench to the buffer layer or the substrate. An effect of total reflection generated by photons when entering the buffer layer or the substrate from the N-type layer may be reduced by providing the second trench.The photons generated by the multi-quantum-well layer may not only be emitted from the substrate, but also may be emitted from side walls of the first trench and the second trench, to change a propagation direction of the photons, such that the photons are reflected a plurality of times inside the LED, thereby reducing the effect of total reflection of the photons in the ultraviolet LED and improving a light extraction efficiency of the ultraviolet LED.

In some embodiments, a bottom width of the second trench a2 is smaller than a bottom width of the first trench a1. Furthermore, a width of the second trench a2 decreases layer by layer along a direction from the P-type layer 25 of the epitaxial layer to the substrate 10.

In some embodiments, the first trench a1 may be formed by performing an etching one time. A etching depth of the first trench a1 is h1, h2< h1 ≤ h3, where h2 is a thickness of the epitaxial layer above the N-type layer 22, h3 is a thickness of the epitaxial layer above the buffer layer 21, and h3-h2 is the thickness of the N-type layer 22. Subsequent processes and a spreadability of material of a passivation layer are taken into account, and thus an etching angle of the first trench a1 ranges from 5° and 75°. The etching angle of the first trench a1 may be calculated based on a total reflection angle of multi-quantum-well layer 23. In some embodiments, the etching angle of the first trench a1 may be 35°. Inclination angles of sidewalls of formed first trench a1 are different due to different etching angles.

The second trench a2 may be obtained by performing an etching a plurality of times. In some embodiments, a first etching is performed on the N-type layer 22 with an etching depth of h4, 0 µm< h4 ≤ h5, h5 being a remaining thickness of N-type layer 22, an etching angle ranging from 5° ~ 80°. A second etching is performed on the buffer layer 21 with an etching depth of h6, 0<h6≤h7, h7 being a thickness of the buffer layer 21, an etching angle ranging from 10°~85°. Thus the second trench a2 with the buffer layer 21 as a bottom is obtained. In this way, the second trench a2 is obtained by performing an etching two times.

**In** some embodiments, a first etching is performed on the N-type layer 22 with an etching depth of h4, 0 µm< h4 ≤ h5, h5 being a remaining thickness of N-type layer 22, an etching angle ranging from 5° ~ 80°. A second etching is performed on the buffer layer 21 with an etching depth of h6, 0<h6≤h7, h7 being a thickness of the buffer layer 21, an etching angle ranging from 10°~85°. A third etching is performed on the substrate 10 with an etching depth of h8, 0< h8 ≤h9, h9 being a thickness of the substrate 10, an etching angleranging from 5°~85°. A second trench a2 with the substrate 10 as a bottom is obtained. In this condition, the second trench a2 is obtained by performing an etching three times.

It should be noted that shapes of cross sections of the first trench a1 and the second trench a2 etched out may be cylindrical, regular trapezoidal, inverted trapezoidal and the like. Sidewalls which are etched out can be roughened. A mesa for etching may be designed as a roughened mesa, photonic crystallized mesa, a patterned mesa and the like. The above are not limited in the embodiments of the invention.

**In** some embodiments, the substrate 10 may be a sapphire substrate. The buffer layer 21 may be an AlN layer. The buffer layer 21 is grown mainly to alleviate a lattice mismatch and thermal mismatch between the sapphire substrate and an AlGaN material. However, the buffer layer 21 should not be too thick, because the buffer layer 21 has a poor crystal quality. If the buffer layer 21 is grown too thick, a growth of subsequent epitaxial structure may be affected and a light may be absorbed, thereby affecting an external quantum efficiency. The N-type layer 22 may be a Si-doped AlGaN layer. The multi-quantum-well layer 23 may include a plurality of quantum well layers and quantum barrier layers that are periodically alternately grown, where the quantum well layer is an AlxGa1-xN layer, 0<x<1, and the quantum barrier layer is an AlyGa1-yN layer, 0<y <1. The quantum well layer and the quantum barrier layer have different contents of Al component, that is, values of x and y are different to provide different band gaps. According to different ultraviolet wavelengths, different combinations of values of x and y may be selected. The P-type layer 25 may be a Mg-doped AlGaN layer. Electrons provided by the N-type layer 22 and holes provided by the P-type layer 25 can implement radiative recombination in the multi-quantum-well layer 23. The N-type electrode 30 may include a stacked-layer metal structure or a combined metal structure in which a metal may include, but not limited to, Cr, Al, Ti, Pt, Au, or an epitaxially secondarily grown high-conductivity n-type semiconductor and the like. For example, the N-type electrode 30, when including the combined metal structure, has a thickness ranging from 200 nm - 500 nm. A material of the P-type electrode 40 includes, but not limited to, NiAu, indium tin oxide, Rh and the like. For example, the P-type electrode 40, when a material thereof is indium tin oxide, has a thickness ranging from 10 nm - 70 nm.

In some embodiments, as shown in FIG. 1, the ultraviolet LED further includes an electron blocking layer 24 disposed between the multi-quantum-well layer 23 and the P-type layer 25. The electron blocking layer 24 may be a Mg-doped AlGaN layer. By disposing the electron blocking layer, electrons can be effectively blocked from escaping from the multi-quantum-well layer 23 to the P-type layer 25, thereby improving an internal quantum efficiency of LED.

In some embodiments, the ultraviolet LED 100 further includes a first contact layer 51 and a second contact layer 52.

Regions of the P-type layer 25 except a region on which the P-type electrode 40 is disposed, sidewalls of the first trench a1, and regions of a bottom of the first trench a1 except a region on which the N-type electrode 30 is disposed are all paved with a first contact layer 51. The first contact layer 51 is a passivation layer or an anti-reflection film layer.

The sidewalls and the bottom of the second trench a2 are both paved with a second contact layer 52. The second contact layer 52 is an anti-reflection film layer or a reflective layer, or the second contact layer 52 has the same material as the N-type electrode or the N-type layer.

The first contact layer 51, when being a passivation layer, can play a role of insulation and protection. An anti-reflection film is a superficial optical coating that increases a transmittance of light on a surface by reducing reflected light. When both the first contact layer 51 and the second contact layer 52 are anti-reflection film layers, a total reflection of light in the ultraviolet LED can be further reduced, thereby improving the light extraction efficiency.

When the second contact layer 52 is a reflective layer, photons that would otherwise be lost can be reflected to a back side of a substrate as much as possible, thereby further improving the light extraction efficiency of a chip. When the second contact layer has the same material as the N-type electrode or the N-type layer, the second contact layer can act as a current expanding layer or a secondary epitaxy contact electrode, thereby reducing a voltage while reducing process steps of the ultraviolet LED, reducing costs and improving yields of the ultraviolet LED. In some embodiments, the second contact layer may include a single-layer metal structure or a stacked-layer metal structure in which a metal may be one or more of Cr, Ti, Al, PT, Au and the like.

In some embodiments, the UV LED 100 further includes a reflective layer 60. The reflective layer 60 covers the N-type electrode 30, the P-type electrode 40, the first contact layer 51, and the second contact layer 52.

In some embodiments, the reflective layer 60 may include a single-layer structure in which a metal may be Al, Rh or the like, or may include a structure of an Omni Directional Reflector (ODR) or DBR (Distributed Bragg Reflector) which is composed of multiple metal layers.

In some embodiments, the reflective layer may be a Cr/Al-based reflective structure, that is, a Cr/Al-doped reflective layer. In this way, the reflective layer not only plays a role of reflecting but also thickens the N-type electrode and the P-type electrode to make the N-type electrode and the P-type electrode have more uniform current expansion.

In some embodiments, the ultraviolet LED further includes an N-type pad 70, a P-type pad 80, and a P-type-pad connection layer 81.

In some embodiments, the P-type-pad connection layer 81 is disposed on a surface of the reflective layer 60 away from the substrate 10, and is located directly above the P-type electrode 40. The P-type pad 80 is located on a surface of the P-type-pad connection layer 81 away from the substrate 10.

The N-type pad 70 is disposed on a surface of the reflective layer 60 away from the substrate 10, and is located directly above the N-type electrode 30.

In some embodiments, the P-type-pad connection layer 81 may be a Cr/Al/Ti/Pt/Au layer, and may have a thickness of, for example, 300 nm. The P-type-pad connection layer 81 can not only connect the P-type electrode, but also thicken the P-type electrode. The N-type pad 70 and the P-type pad 80 may have a material of Au or Sn, and a thickness of 1.9 µm.

In some embodiments, the ultraviolet LED further includes a passivation layer 90. Regions of the reflective layer 60 except regions on which the P-type-pad connection layer 81 and the N-type pad 70 are disposed are all paved with the passivation layer 90 thereon. The passivation layer 90 can play an role of insulating and protecting. Exemplarity, a thickness of the passivation layer 90 may be 1 µm.

It should be noted that the ultraviolet LED provided in the embodiment of the invention may be a UVA long-wave ultraviolet LED, or a UVB medium-wave ultraviolet LED or a UVC short-wave ultraviolet LED, and the invention does not limit this.

A method for manufacturing an ultraviolet LED is also provided according to an embodiment of the invention, which is used to manufacture the ultraviolet LED shown in FIG. 1. As shown in FIG. 2, the method includes Step 201 to Step 204.

In Step 201, an epitaxial layer is grown on a substrate to obtain an epitaxial wafer.

In some embodiments, the substrate may be a sapphire substrate. The epitaxial layer includes a buffer layer, an N-type layer, a multi-quantum-well layer, an electron blocking layer and a P-type layer which are sequentially grown on the substrate. The descriptions for each epitaxial layer can be found in the related description related to FIG. 1, which will not be described again here.

In some embodiments, a growth of the epitaxial layer may be achieved using Veeco K465i or C4 or RB MOCVD (Metal Organic Chemical Vapor Deposition) apparatus. High-purity H₂ (hydrogen) or high-purity N₂ (nitrogen) or a mixed gas of high-purity H₂ and high-purity N₂ is used as a carrier gas. High-purity NH₃ is used as a N source. A trimethylgallium (TMGa) and a triethylgallium (TEGa) are used as a gallium source. A trimethylindium (TMIn) is used as an indium source. A silane (SiH4) is used as an N-type dopant. A trimethylaluminum (TMAl) is used as an aluminum source. A bis(cyclopentadienyl)magnesium (CP₂Mg) is used as a P-type dopant.

In some embodiments, the manufacturing method for , after step S201 is performed and before step S202 is performed, may further include:

The epitaxial wafer is ultrasonically cleaned with an acetone and isopropanol for 5 minutes respectively to remove superficial organic matters, then rinsed with a deionized water for 5 minutes and dried in a spin dryer.

In Step 202, the epitaxial layer is etched a plurality of times to form a first trench and a second trench on the epitaxial layer.

In some embodiments, the first trench is extended from the P-type layer to the N-type layer, and a bottom of the first trench is the N-type layer. The second trench is extended from the N-type layer which is the bottom of the first trench to the buffer layer or the substrate. The bottom of the second trench is the buffer layer or the substrate.

In some embodiments, the first trench a1 can be formed by performing an etching one time. A positive photoresist may be used as a mask to perform a mesa etching on the epitaxial wafer using inductively coupled plasma (ICP), with an etching selectivity ratio of 3:1, an etching depth of 450~850nm, and an etching angle of 35°. An etched epitaxial wafer is placed in a degumming solution of 85°C, the acetone and isopropanol for ultrasonic treatments for 10 min, 5 min and 5 min, respectively, and then rinsed with the deionized water for 5 min to remove the positive photoresist on a surface of the etched epitaxial wafer to form a first trench.

In some embodiments, the second trench may be obtained by performing an etching a plurality of times. In some embodiments, a first etching is performed on the N-type layer with an etching depth of h4, 0 µm< h4 ≤ h5, h5 being a remaining thickness of N-type layer, an etching angle ranging from 5° ~ 80°. A second etching is performed on the buffer layer with an etching depth of h6, 0<h6≤h7, h7 being a thickness of the buffer layer 21, an etching angle ranging from 10°~85°. A second trench with the buffer layer as a bottom is obtained. In this condition, the second trench is obtained by performing an etching two times.

In some embodiments, a first etching is performed on the N-type layer with an etching depth of h4, 0 µm< h4 ≤ h5, h5 being a remaining thickness of N-type layer, an etching angle ranging from 5° ~ 80° (which may be 45°). A second etching is performed on the buffer layer with an etching depth of h6, 0<h6≤h7, h7 being a thickness of the buffer layer 21, an etching angle ranging from 10°~85° (which may be 55°). A third etching is performed on the substrate with an etching depth of h8, 0< h8 ≤h9, h9 being a thickness of the substrate 10, an etching angle ranging from 5°~85°. A second trench with the substrate as a bottom is obtained.

In some embodiments, when the N-type layer and the buffer layer are etched, a positive photoresist may be used as a mask, and an etching may be performed by using inductively coupled plasma (ICP) in a mixed atmosphere of BCl₃ and Cl₂. The positive photoresist may have a certain angle relative to the mesa by adjusting a distance between the mask and a sample. A thickness of the positive photoresist may be 8 µm~10 µm. Since the substrate is more difficult to be etched than the epitaxial layer, the substrate can be etched by a combined dry etching and wet etching with a silicon dioxide and photoresist together as a mask. When the substrate is etched, an etching angle may be 36° and an etching depth may be 20 µm~30 µm.

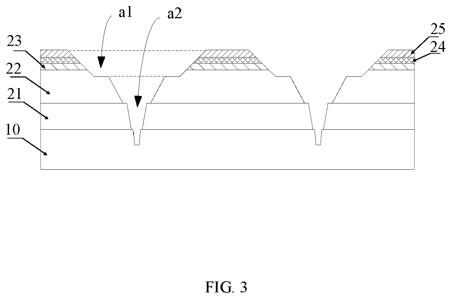

As shown in FIG. 3, at this time, a first trench a1 and a second trench a2 are formed on the epitaxial wafer.

In some embodiments, the manufacturing method, after step S202 is performed and before step S203 is performed, may further include:
A scribe-line etching is performed on the epitaxial wafer.

In some embodiments, a scribe-line etching may be performed on the epitaxial wafer by a way of ICP etching, with an etching depth of 4-5 µm. The scribe-line etching is performed on the epitaxial wafer to facilitate subsequent scribing on the epitaxial wafer.

In Step 203, an N-type electrode is formed on the N-type layer which is a bottom of the first trench.

In some embodiments, the N-type electrode may include a stacked-layer metal structure or a combined metal structure in which a metal may include, but not limited to, Cr, Al, Ti, Pt, Au, or an epitaxially secondarily grown high-conductivity n-type semiconductor and the like. In some embodiments, the N-type electrode, when including the combined metal structure, has a thickness ranging from 200 nm - 500 nm.

In some embodiments, the N-type electrode may be formed by a way of evaporating, annealing, or etching, which are conventional techniques and will not be described in detail herein. Annealing conditions for the N-type electrode may be a nitrogen atmosphere, 800°C~900°C, and rapid annealing for 1 minute.

In Step 204, a P-type electrode is formed on the P-type layer which is outside the first trench.

In some embodiments, a material of the P-type electrode includes, but not limited to, NiAu, indium tin oxide, Rh and the like. For example, the P-type electrode, when a material thereof is indium tin oxide, has a thickness ranging from 10 nm - 70 nm.

In some embodiments, the P-type electrode may be formed by a way of evaporating, annealing, or etching, which are conventional techniques and will not be described in detail herein. In some embodiments, annealing conditions of the P-type electrode may be an oxygen atmosphere, 500° C, and rapid annealing for 5 min.

In some embodiments, the method may further include:
A first contact layer is formed on regions of the P-type layer except a region on which the P-type electrode is disposed, sidewalls of the first trench, and regions of a bottom of the first trench except a region on which the N-type electrode is disposed. The first contact layer is a passivation layer or an anti-reflection film layer.

A second contact layer is formed on sidewalls and the bottom of the second trench. The second contact layer is an anti-reflection film layer or a reflective layer, or the second contact layer has the same material as the N-type electrode or the N-type layer.

In some embodiments, when the first contact layer is a passivation layer, the passivation layer may be deposited by using a way of PECVD (Plasma Enhanced Chemical Vapor Deposition). When the first contact layer and the second contact layer are anti-reflection film layers, a silicon dioxide layer with a thickness of an odd multiple of a quarter wavelength of an ultraviolet light emitted by the ultraviolet LED can be deposited by the way of PECVD to obtain the anti-reflection film layer. When the second contact layer is a reflective layer, the reflective layer can be deposited by electron beam evaporation, or multiple passivation layers are deposited by alternately stacking materials with high refractive index and materials with low refractive index with PECVD apparatus or with an electron gun (E-Gun) vacuum evaporating system to obtain the reflective layer. Whenthe second contact layer has the same material as the N-type electrode or the N-type layer, the second contact layer can be prepared by an electron beam evaporation or a magnetron sputtering and the like.

In some embodiments, the method may further include:
A reflective layer is formed on the N-type electrode, the P-type electrode, the first contact layer and the second contact layer.

In some embodiments, a negative photoresist may be used as a mask, and a way of electron beam evaporation may be used to prepare a reflective layer, and then a stripping solution may be used to strip the negative photoresist.

In some embodiments, the method may further include:
A P-type-pad connection layer is formed on a surface of the reflective layer away from the substrate, and is located directly above the P-type electrode. A P-type pad is formed on a surface of the P-type-pad connection layer away from the substrate. An N-type pad is formed on a surface of the reflective layer away from the substrate, and is located directly above the N-type electrode.

In some embodiments, the P-type-pad connection layer, the P-type pad, and the N-type pad may be prepared by a way of evaporating. In some embodiments, before the P-type-pad connection layer is prepared, a silicon dioxide protection layer may be deposited by PECVD on a surface of the reflective layer away from the substrate to protect the reflective layer. Then, the silicon dioxide protection layer directly above the P-type layer is corroded, and metal Cr/Al/Ti/Pt/Au is evaporated in a corroded region to form the P-type-pad connection layer. Finally, a remaining silicon dioxide protection layer can be removed by a process of photolithography mask and ICP etching. A way of evaporating for the P-type pad and the N-type pad is similar to that of the P-type-pad connection layer, and an evaporated metal may be an Au or Sn.

In some embodiments, the method further include:
A passivation layer is formed on regions of the reflective layer except a region on which the P-type-pad connection layer and the N-type pad are disposed.

In some embodiments, the passivation layer may be prepared by a way of evaporating, with an evaporating thickness of about 1 µm and an evaporating temperature of about 220°C.

It should be noted that the passivation layer may be formed after the P-type-pad connection layer is prepared and before the P-type pad and the N-type pad are prepared.

In summary, according to some embodiments of the invention, an internal structure of the ultraviolet LED is changed by forming the first trench and the second trench in the LED. The first trench is extended from the P-type layer to the N-type layer, and the second trench is extended from the N-type layer which is the bottom of the first trench to the buffer layer or the substrate. A effect of total reflection generated by photons when entering the buffer layer or the substrate from the N-type layer may be reduced by providing the second trench. The photons generated by the multi-quantum-well layer may not only be emitted from the substrate, but also may be emitted from side walls of the first trench and the second trench, to change a propagation direction of the photons, such that the photons are reflected a plurality of times inside the LED, thereby reducing the effect of total reflection of the photons in the ultraviolet LED and improving a light extraction efficiency of the ultraviolet LED.

The above description is only an optional embodiment of the invention and is not intended to limit the invention. Any modifications, equivalent substitutions, improvements and the like made within a spirit and principles of the invention shall be included in the scope sought for by the invention.

## Claims

1. An ultraviolet LED, comprising a substrate, an epitaxial layer, an N-type electrode and a P-type electrode, wherein the epitaxial layer comprises a buffer layer, an N-type layer, a multi-quantum-well layer and a P-type layer sequentially stacked on the substrate;
the ultraviolet LED has a first trench and a second trench;
the first trench is extended from the P-type layer to the N-type layer, a bottom of the first trench being the N-type layer, the N-type electrode being disposed on the N-type layer which is the bottom of the first trench, the P-type electrode being disposed on the P-type layer which is outside the first trench; and
the second trench is extended from the N-type layer which is the bottom of the first trench to the buffer layer or the substrate, a bottom of the second trench being the buffer layer or the substrate.

2. The ultraviolet LED of claim 1, further comprising a first contact layer and a second contact layer, wherein,
regions of the P-type layer except a region on which the P-type electrode is disposed, sidewalls of the first trench, and regions of the bottom of the first trench except a region on which the N-type electrode is disposed, are paved with the first contact layer thereon, the first contact layer being a passivation layer or an anti-reflection film layer; and
sidewalls and the bottom of the second trench are both paved with the second contact layer, the second contact layer being an anti-reflection film layer or a reflective layer, or the second contact layer having the same material as the N-type electrode or the N-type layer.

3. The ultraviolet LED of claim 1, further comprising a reflective layer, wherein the reflective layer covers the N-type electrode, the P-type electrode, the first contact layer and the second contact layer.

4. The ultraviolet LED of claim 1, further comprising an N-type pad, a P-type pad and a P-type-pad connection layer, wherein,
the P-type-pad connection layer is disposed on a surface of the reflective layer away from the substrate, and is located directly above the P-type electrode, and wherein the P-type pad is located on a surface of the P-type-pad connection layer away from the substrate; and
the N-type pad is disposed on a surface of the reflective layer away from the substrate, and is located directly above the N-type electrode.

5. The ultraviolet LED of claim 1, further comprising a passivation layer, wherein regions of the reflective layer except regions on which the P-type-pad connection layer and the N-type pad are disposed are all paved with the passivation layer thereon.

6. A method for manufacturing an ultraviolet LED, comprising:
growing an epitaxial layer on a substrate to obtain an epitaxial wafer, wherein the epitaxial layer comprises a buffer layer, an N-type layer, a multi-quantum-well layer and a P-type layer grown in sequence on the substrate;
performing an etching on the epitaxial layer a plurality of times to form a first trench and a second trench on the epitaxial layer, the first trench being extended from the P-type layer to the N-type layer, a bottom of the first trench being the N-type layer, the second trench being extended from the N-type layer which is a bottom of the first trench to the buffer layer or the substrate, a bottom of the second trench being the buffer layer or the substrate;
forming an N-type electrode on the N-type layer which is the bottom of the first trench; and
forming a P-type electrode on the P-type layer which is outside the first trench.

7. The method of claim 6, further comprising:
forming a first contact layer on regions of the P-type layer except a region on which the P-type electrode is disposed, on sidewalls of the first trench, and on regions of the bottom of the first trench except a region on which the N-type electrode is disposed, the first contact layer being a passivation layer or an anti-reflection film layer; and
forming a second contact layer on sidewalls and the bottom of the second trench, the second contact layer being an anti-reflection film layer or a reflective layer, or the second contact layer having the same material as the N-type electrode or the N-type layer.

8. The method of claim 7, further comprising:
forming a reflective layer on the N-type electrode, the P-type electrode, the first contact layer and the second contact layer.

9. The method of claim 8, further comprising:
forming a P-type-pad connection layer on a surface of the reflective layer away from the substrate, the P-type-pad connection layer being located directly above the P-type electrode;
forming a P-type pad on a surface of the P-type-pad connection layer away from the substrate; and
forming an N-type pad on a surface of the reflective layer away from the substrate, the N-type pad being located directly above the N-type electrode.

10. The method of claim 9, further comprising:
forming a passivation layer on regions of the reflective layer except regions on which the P-type-pad connection layer and the N-type pad are disposed.
